(19) Europäisches Patentamt
European Patent Office
Office européen des brevets

(11) EP 4 691 782 A1

(12) # EUROPEAN PATENT APPLICATION

(43) Date of publication:
**11.02.2026 Bulletin 2026/07**

(21) Application number: **25193967.4**

(22) Date of filing: **05.08.2025**

(51) International Patent Classification (IPC):
***B41J 2/16*** *(2006.01)* ***C08G 59/04*** *(2006.01)*
***C08G 59/06*** *(2006.01)* ***C08G 59/08*** *(2006.01)*
***C08G 59/30*** *(2006.01)* ***C08G 59/62*** *(2006.01)*
***C08G 59/68*** *(2006.01)* ***C08L 63/00*** *(2006.01)*
***C08G 59/24*** *(2006.01)* ***C08G 77/14*** *(2006.01)*
***C08L 63/04*** *(2006.01)*

(52) Cooperative Patent Classification (CPC):
(C-Sets available)
**B41J 2/1603; B41J 2/1628; B41J 2/1629; B41J 2/1631; B41J 2/1639; B41J 2/1645; C08G 59/04; C08G 59/06; C08G 59/08; C08G 59/24; C08G 59/306; C08G 59/62; C08G 59/621; C08G 59/687; C08G 77/14;** (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.08.2024 JP 2024130114**
**02.05.2025 JP 2025076608**

(71) Applicant: **Canon Kabushiki Kaisha**
**Tokyo, 146-8501 (JP)**

(72) Inventors:
- **YAMAJI, Haruka**
  **Tokyo 146-8501 (JP)**
- **ISHII, Miho**
  **Tokyo 146-8501 (JP)**
- **KOBATAKE, Erika**
  **Tokyo 146-8501 (JP)**
- **TSUTSUI, Satoshi**
  **Tokyo 146-8501 (JP)**
- **HAMADE, Yohei**
  **Tokyo 146-8501 (JP)**
- **TAKAI, Yu**
  **Tokyo 146-8501 (JP)**

(74) Representative: **TBK**
**Bavariaring 4-6**
**80336 München (DE)**

(54) **PHOTOSENSITIVE RESIN COMPOSITION, LIQUID-REPELLENT ANTI-FOULING FILM, AND INKJET RECORDING HEAD**

(57) A photosensitive resin composition comprising: an epoxy resin (A) represented by formula (1); an epoxy resin (B) that has an epoxy equivalent of 500 g/eq. or less and that is different from the epoxy resin (A) represented by formula (1); and a cationic polymerization catalyst,

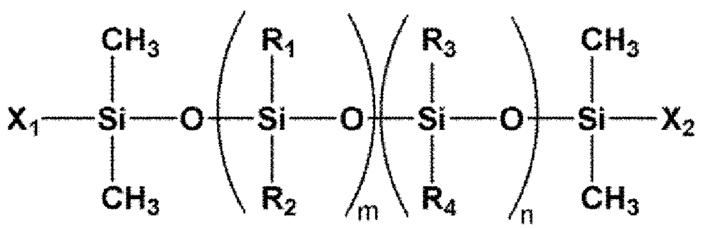

(1)

where, in formula (1), $R_1$, $R_2$, $R_3$, $R_4$, and $X_1$ are each independently an alkyl group with carbon numbers of 1 to 12, an aryl group with carbon numbers of 6 to 12, or an epoxy-comprising group; $X_2$ is an epoxy-comprising group; m + n is an integer from 1 to 60; and a sequence of a structure of parentheses marked with m and a sequence of a structure of parentheses marked with n may be random or block.

EP 4 691 782 A1

Fig. 2A

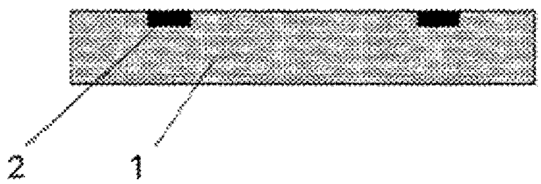


Fig. 2B

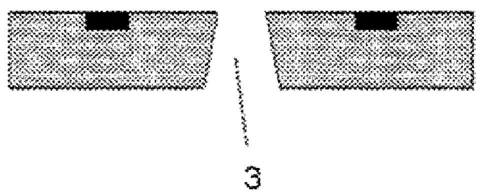


Fig. 2C

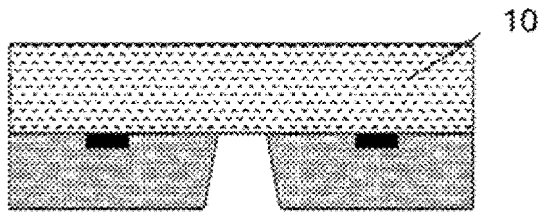


Fig. 2D

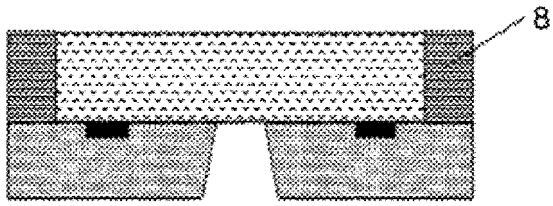


Fig. 2E

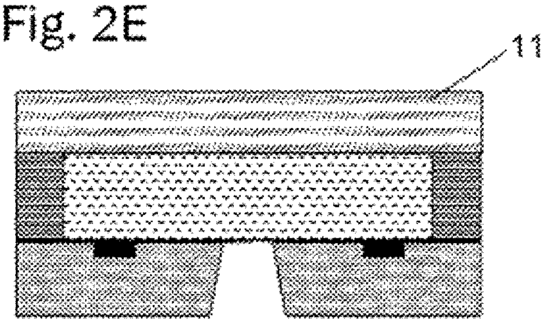


Fig. 2F

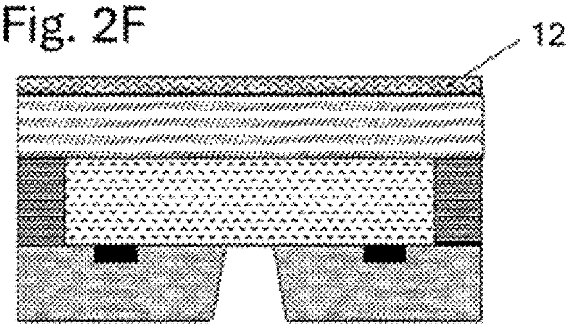


Fig. 2G

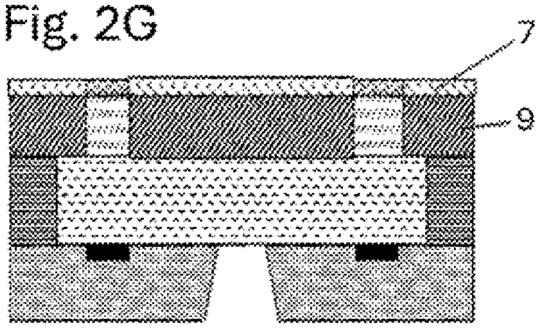


Fig. 2H

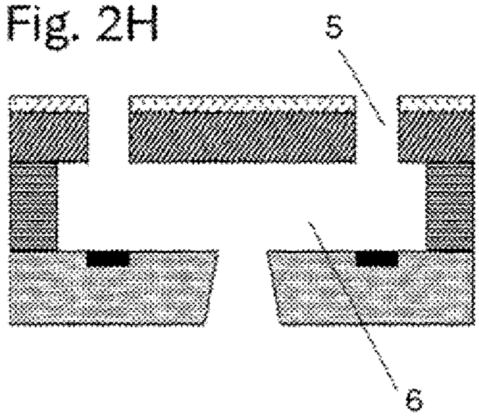


(52) Cooperative Patent Classification (CPC): (Cont.)
**C08L 63/00; C08L 63/04**

C-Sets
**C08L 63/00, C08L 83/06;**
**C08L 63/04, C08L 83/06**

## Description

TECHNICAL FIELD

The present disclosure relates to a photosensitive resin composition, a liquid-repellent anti-fouling film, and an inkjet recording head.

BACKGROUND

Fluorine-based water-repellent materials are generally known as materials that form liquid-repellent anti-fouling films, and in particular compounds bearing perfluoroalkyl groups or perfluoropolyether groups exhibit an excellent liquid repellency and an excellent durability and are thus widely used in a variety of applications. However, since fluorine-comprising compounds exhibit a high chemical stability and are resistant to degradation, if they are continuously discharged into the environment they may remain present in the environment on a long-term basis and can, by moving through the environment and food chain, affect human health and the habitat and growth of animals and plants. As a consequence, in order to realize a sustainable society such as a recycling-oriented society, there has been a desire in recent years for a switch from fluorine-based water-repellent materials to non-fluorine-based water-repellent materials.

Silicone compounds are water-repellent materials that do not comprise fluorine, but which still exhibit an excellent liquid repellency and can thus be used as an alternative to fluorine-based water-repellent materials. Silicone compounds can eliminate, inter alia, concerns with environmental impact and concerns with regard to fluorine sources.

For example, Japanese Patent Laid-open No. 2003-20323 discloses a technology that uses a silicone compound, and particularly an epoxy-comprising resin composition, as a non-fluorine-based composition. The composition described in Japanese Patent Laid-open No. 2003-20323 comprises a photopolymerization initiator and as a result can rapidly and very accurately form a liquid-repellent anti-fouling film by photocuring.

SUMMARY

However, silicone compounds generally do not exhibit very high reactivity with epoxy resins, and as a consequence the crosslink density may be inadequate and an acceptable liquid repellency may not be obtained. For example, when used for the surface treatment of inkjet heads, the pigment component comprised in the ink may stick or a structural deterioration may be produced by the alkaline component and it may not be possible to retain a good print quality during long-term use. To respond to this, methods have been considered in which the crosslink density is improved by increasing the photoexposure dose or increasing the photopolymerization initiator, but this affects the resolution during patterning and as a consequence it is difficult to achieve both this and an improved liquid repellency.

The present disclosure provides a photosensitive resin composition that exhibits satisfactory reactivity during curing and that can realize a high liquid repellency and good resolution during patterning. The present disclosure also provides a liquid-repellent anti-fouling film that can realize a high liquid repellency as well as good resolution during patterning. The present disclosure additionally provides an inkjet recording head that can realize a high liquid repellency as well as good resolution during patterning.

The present disclosure in its first aspect provides a photosensitive resin composition as specified in claim 1. Optional features are specified in claim 2 to 10.

The present disclosure in its second aspect provides a liquid-repellent anti-fouling film as specified in claim 11.

The present disclosure in its third aspect provides an inkjet recording head as specified in claim 12.

Features of the present disclosure will become apparent from the following description of embodiments with reference to the attached drawings. The following description of embodiments is described by way of example.

The present disclosure provides a photosensitive resin composition that exhibits satisfactory reactivity during curing and that can realize a high liquid repellency and good resolution during patterning. The present disclosure also provides a liquid-repellent anti-fouling film that can realize a high liquid repellency and good resolution during patterning. The present disclosure can additionally provide an inkjet recording head that can realize a high liquid repellency as well as good resolution during patterning.

BRIEF DESCRIPTION OF THE DRAWINGS

FIGS. 1A and 1B are schematic diagrams of an inkjet recording head that employs a liquid-repellent anti-fouling film;
FIGS. 2A to 2H are diagrams for describing an example of a method for producing an inkjet recording head that uses a liquid-repellent anti-fouling film; and

FIGS. 3A to 3C are diagrams for describing a procedure for forming a liquid-repellent anti-fouling film.

## DESCRIPTION OF THE EMBODIMENTS

In the present disclosure, the expression of "from XX to YY" or "XX to YY" indicating a numerical range means a numerical range including a lower limit and an upper limit which are end points, unless otherwise specified. Also, when a numerical range is described in a stepwise manner, the upper and lower limits of each numerical range can be arbitrarily combined. In addition, in the present disclosure, for example, descriptions such as "at least one selected from the group consisting of XX, YY and ZZ" mean any of XX, YY, ZZ, the combination of XX and YY, the combination of XX and ZZ, the combination of YY and ZZ, and the combination of XX, YY, and ZZ.

The components for obtaining the photosensitive resin composition according to the present disclosure are described in the following.

### The Epoxy Resin (A)

The photosensitive resin composition comprises the epoxy resin (A) represented by formula (1). The epoxy resin (A) represented by formula (1) has an epoxy group in the molecule. The epoxy resin (A) represented by formula (1) functions as the water-repellent component.

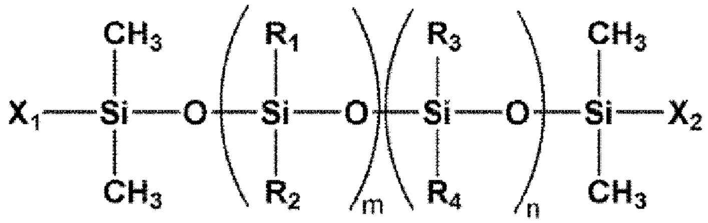

(1)

In formula (1), $R_1$, $R_2$, $R_3$, $R_4$, and $X_1$ are each independently an alkyl group with carbon numbers of 1 to 12, an aryl group with carbon numbers of 6 to 12, or an epoxy-comprising group; $X_2$ is an epoxy-comprising group; and m + n is an integer from 1 to 60.

The epoxy-comprising group can be exemplified by groups that have a glycidyl ether group and groups that have an alicyclic epoxy group. The epoxy-comprising group is preferably a group having a glycidyl ether group or a group having an epoxycyclohexyl group.

The epoxy-comprising group is more preferably a glycidoxyalkyl group in which the alkyl chain has 1 to 4 (preferably 2 to 4) carbons or an epoxycyclohexylalkyl group in which the alkyl chain has 1 to 8 (preferably 2 to 6) carbons. The epoxy-comprising group is still more preferably a 3-glycidoxyalkyl group in which the alkyl chain has 1 to 4 (preferably 2 to 4) carbons or a 2-(3,4-epoxycyclohexyl)alkyl group in which the alkyl chain has 1 to 8 (preferably 2 to 6) carbons.

More preferred examples of the epoxy-comprising group are the 3-glycidoxypropyl group and 2-(3,4-epoxycyclohexyl)ethyl group. Epoxycyclohexylalkyl groups in particular enable the generation of an excellent reactivity and a high liquid repellency.

Additionally, $R_1$, $R_2$, $R_3$, and $R_4$ are each independently preferably an alkyl group with carbon numbers of 1 to 12 or an aryl group with carbon numbers of 6 to 12. In this case, the epoxy resin (A) has an epoxy group only in terminal position in the molecular structure. As a result, the orientation of the siloxane main chain is improved and a high water repellency is obtained.

$X_1$ is preferably an epoxy-comprising group. When $X_1$ is an epoxy-comprising group, it is then an epoxy-comprising group along with $X_2$. In this case, due to the firm anchoring in the film while maintaining the orientation of the siloxane main chain, it is possible to achieve an excellent durability and to maintain the liquid repellency on a long-term basis.

The alkyl group with carbon numbers of 1 to 12in formula (1) is particularly preferably an alkyl group with carbon numbers of 1 to 4, e.g., methyl group, ethyl group, propyl group, and so forth. From the standpoints of the compatibility with resins and the film strength, for example, the phenyl group may be present as the aryl group with carbon numbers of 6 to 12.

From the standpoints of the compatibility with resins and the solubility in solvents, m + n in formula (1) is an integer from 1 to 60 and preferably an integer from 10 to 60. An integer from 30 to 60 is more preferred from the standpoint of the liquid repellency.

The m in formula (1) is preferably 0 or 1. In addition, a sequence of a structure of parentheses marked with m and a sequence of a structure of parentheses marked with n may be random or block. Preferably the sequence of the structure of parentheses marked with m and the sequence of the structure of parentheses marked with n is random.

The Epoxy Resin (B)

The photosensitive resin composition has an epoxy resin (B) that has an epoxy equivalent of 500 g/eq. or less. This epoxy resin (B) is an epoxy resin that is different from the epoxy resin (A) represented by formula (1). When the epoxy equivalent is greater than 500 g/eq., there is then a large difference between the reactivity of the epoxy resin (B) and the reactivity of the epoxy resin (A). The epoxy resin (A) may then aggregate and/or the reaction may proceed in only one resin, and the reaction may thus not proceed uniformly and adequately. A desirable liquid repellency or resolution may then not be obtained as a result. An epoxy equivalent of 300 g/eq. or less is still more favorable from the standpoint in particular of the resolution.

There is no particular limitation on the lower limit for the epoxy equivalent, and the epoxy equivalent may be, for example, 50 to 500 g/eq., or 100 to 500 g/eq., or 100 to 300 g/eq.

The epoxy equivalent is defined as (molecular weight of the epoxy resin / number of epoxy groups in one molecule of the epoxy resin).

The skeleton of the epoxy resin (B) can be selected considering the adhesion performance, mechanical strength, and swelling resistance of its cured product. The epoxy resin (B) is preferably at least one selected from the group consisting of epoxy resin having an alicyclic skeleton, epoxy resin having a bisphenol skeleton, epoxy resin having a phenol novolac skeleton, epoxy resin having a cresol novolac skeleton, epoxy resin having a norbornene skeleton, epoxy resin having a terpene skeleton, epoxy resin having a dicyclopentadiene skeleton, and epoxy resin having an oxycyclohexane skeleton.

More specifically, examples are cationic polymerizable epoxy resins, e.g., polyfunctional epoxy resins, for example, epoxy resin having a bisphenol skeleton such as bisphenol A epoxy resin and bisphenol F epoxy resin, epoxy resin having a phenol novolac skeleton such as phenol novolac epoxy resin epoxy resin having a cresol novolac skeleton such as cresol novolac epoxy resin epoxy resin having a norbornene skeleton, epoxy resin having a terpene skeleton, epoxy resin having a dicyclopentadiene skeleton, and epoxy resin having an oxycyclohexane skeleton. A single one of these may be used or a combination of two or more may be used.

The epoxy resin (B) is more preferably at least one selected from the group consisting of epoxy resin having an alicyclic skeleton, epoxy resin having a bisphenol skeleton, epoxy resin having a phenol novolac skeleton, epoxy resin having a cresol novolac skeleton, and epoxy resin having a dicyclopentadiene skeleton.

Commercially available epoxy resin (B) include "jER157S70" and "jER1031S" (product names) from the Mitsubishi Chemical Corporation; "Epiclon N-695" and "Epiclon N-865" (product names) from the DIC Corporation; "Celloxide 2021", "GT-300 series", "GT-400 series", and "EHPE3150" (product names) from the Daicel Corporation; "SU8" (product name) from Nippon Kayaku Co., Ltd.; "VG3101" (product name) and "EPOX-MKR1710" (product name) from the Printec Corporation; and "Denacol series" from the Nagase ChemteX Corporation.

The mass ratio (A : B) between the epoxy resin (A) and the epoxy resin (B) is preferably from 0.3 : 100 to 30 : 100. When the amount of the epoxy resin (A) is less than 0.3, the liquid repellency may in some cases be inadequate depending on the application. When, on the other hand, it is more than 30, the compatibility may be reduced and long-term storage may be problematic depending on the species of epoxy resin (B). A : B is more preferably from 0.3 : 100 to 15 : 100, and A : B is still more preferably from 0.3 : 100 to 5 : 100.

The total content of the epoxy resin (A) and the epoxy resin (B) in the photosensitive resin composition is not particularly limited, but is preferably 90 to 99 mass%, more preferably 93 to 99 mass%, and still more preferably 95 to 99 mass%.

The Cationic Polymerization Catalyst

The photosensitive resin composition comprises a cationic polymerization catalyst. When the photosensitive resin composition is coated onto a substrate and cured, due to the presence of the cationic polymerization catalyst a water-repellent anti-fouling film can be formed by generating a cured product through exposure to light. In this case, the liquid repellency and mechanical strength are substantially improved in comparison to thermal curing and microfine processing by patterning is also made possible. The cationic polymerization catalyst comprises a cation and an anion.

Sulfonic acid compounds, diazomethane compounds, sulfonium salt compounds, iodonium salt compounds, disulfone compounds, and so forth are preferred for the cationic polymerization catalyst.

Among these, sulfonium, which has a high i-line (wavelength of 365 nm) absorbance and exhibits an excellent cationic polymerization performance and an excellent crosslinking reactivity, is more preferred. The cation in the cationic polymerization catalyst is preferably a sulfonium ion.

The following are specific examples of sulfonium-type cationic ions:

triarylsulfoniums such as triphenylsulfonium, tri-p-tolylsulfonium, tri-o-tolylsulfonium, tris(4-methoxyphenyl)sulfonium, 1-naphthyldiphenylsulfonium, 2-naphthyldiphenylsulfonium, tris(4-fluorophenyl)sulfonium, tri-1-naphthylsulfonium, tri-2-naphthylsulfonium, tris(4-hydroxyphenyl)sulfonium, 4-(phenylthio)phenyldiphenylsulfonium, 4-(p-tolylthio)phenyldi-p-tolylsulfonium, 4-(4-methoxyphenylthio)phenylbis(4-methoxyphenyl)sulfonium, 4-(phenylthio)phenylbis(4-fluorophenyl)sulfonium, 4-(phenylthio)phenylbis(4-methoxyphenyl)sulfonium, 4-(phenylthio)phenyldi-p-tolylsulfonium, [4-(4-biphenylylthio)phenyl]-4-biphenylylphenylsulfonium, [4-(2-thioxanthonylthio)phenyl]diphenylsulfonium, bis[4-(diphenylsulfonio)phenyl] sulfide, bis[4-{bis[4-(2-hydroxyethoxy)phenyl]sulfonio}phenyl] sulfide, bis{4-[bis(4-fluorophenyl)sulfonio]phenyl} sulfide, bis{4-[bis(4-methylphenyl)sulfonio]phenyl} sulfide, bis{4-[bis(4-methoxyphenyl)sulfonio]phenyl} sulfide, 4-(4-benzoyl-2-chlorophenylthio)phenylbis(4-fluorophenyl)sulfonium, 4-(4-benzoyl-2-chlorophenylthio)phenyldiphenyl sulfonium, 4-(4-benzoylphenylthio)phenylbis(4-fluorophenyl)sulfonium, 4-(4-benzoylphenylthio)phenyldiphenylsulfonium, 7-isopropyl-9-oxo-10-thia-9,10-dihydroanthracen-2-yldi-p-tolylsulfonium, 7-isopropyl-9-oxo-10-thia-9,10-dihydroanthracen-2-yldiphenylsulfonium, 2-[(di-p-tolyl)sulfonio]thioxanthone, 2-[(diphenyl)sulfonio]thioxanthone, 4-(9-oxo-9H-thioxanthen-2-yl)thiophenyl-9-oxo-9H-thioxanthen-2-ylphenylsulfonium, 4-[4-(4-tert-butylbenzoyl)phenylthio]phenyldi-p-tolylsulfonium, 4-[4-(4-tert-butylbenzoyl)phenylthio]phenyldiphenylsulfonium, 4-[4-(benzoylphenylthio)]phenyldi-p-tolylsulfonium, 4-[4-(benzoylphenylthio)]phenyldiphenylsulfonium, 5-(4-methoxyphenyl)thianthrenium, 5-phenylthianthrenium, 5-tolylthianthrenium, 5-(4-ethoxyphenyl)thianthrenium, and 5-(2,4,6-trimethylphenyl)thianthrenium;

diarylsulfoniums such as diphenylphenacylsulfonium, diphenyl-4-nitrophenacylsulfonium, diphenylbenzylsulfonium, and diphenylmethylsulfonium;

monoarylsulfoniums such as phenylmethylbenzylsulfonium, 4-hydroxyphenylmethylbenzylsulfonium, 4-methoxyphenylmethylbenzylsulfonium, 4-acetocarbonyloxyphenylmethylbenzylsulfonium, 4-hydroxyphenylmethyl-1-naphthylmethylsulfonium, 4-hydroxyphenyl(2-naphthylmethyl)methylsulfonium, 2-naphthylmethylbenzylsulfonium, 2-naphthylmethyl(1-ethoxycarbonyl)ethylsulfonium, phenylmethylphenacylsulfonium, 4-hydroxyphenylmethylphenacylsulfonium, 4-methoxyphenylmethylphenacylsulfonium, 4-acetocarbonyloxyphenylmethylphenacylsulfonium, 2-naphthylmethylphenacylsulfonium, 2-naphthyloctadecylphenacylsulfonium, and 9-anthracenylmethylphenacylsulfonium; and

trialkylsulfoniums such as dimethylphenacylsulfonium, phenacyltetrahydrothiophenium, dimethylbenzylsulfonium, benzyltetrahydrothiophenium, and octadecylmethylphenacylsulfonium.

The molar extinction coefficient of the cationic polymerization catalyst at a wavelength of 365 nm is preferably 400 $M^{-1} \cdot cm^{-1}$ or more. By having the molar extinction coefficient be 400 $M^{-1} \cdot cm^{-1}$ or more, the photopatternability can be improved while achieving additional improvements in the liquid repellency without reducing the crosslink density during the curing reaction.

Measurement of the molar extinction coefficient of a compound, e.g., the cationic polymerization catalyst, is carried out as follows.

A solution is prepared by dissolving the target compound in a solvent that does not absorb at 365 nm, for example, acetonitrile. The resulting solution is introduced into a quartz cell and the absorbance at 365 nm is measured using a UV-Vis-Infrared spectrophotometer (JASCO Corporation). The molar extinction coefficient can be calculated from the obtained absorbance using the following formula.

Molar extinction coefficient = absorbance ÷ molar concentration ÷ optical path length of the cell

For example, a high-acid-strength borate type or phosphorus type, antimony type, or gallate type can be selected for the anion moiety of the cationic polymerization catalyst.

Among these, the tetrakis(pentafluorophenyl)borate ion, trifluorotris(pentafluoroethyl)phosphate ion, hexafluoroantimonate ion, and tetrakis(pentafluorophenyl)gallate ion, which exhibit an excellent cationic polymerization performance and an excellent crosslinking reactivity, are more preferred. The use of these makes it possible to improve the photopatternability while achieving additional improvements in the liquid repellency.

The anion in the cationic polymerization catalyst is preferably at least one selected from the group consisting of the tetrakis(pentafluorophenyl)borate ion, trifluorotris(pentafluoroethyl)phosphate ion, hexafluoroantimonate ion, and tetrakis(pentafluorophenyl)gallate ion.

The following are examples of cationic polymerization catalyst that can be favorably used: commercially available products such as "ADEKA ARKLS SP-170", "ADEKA ARKLS SP-172", and "ADEKA ARKLS SP-150" (all product names) from the ADEKA Corporation, and "BBI-103" and "BBI-102" (all product names) from Midori Kagaku Co., Ltd. Other examples are "IBPF", "IBCF", "TS-01", and "TS-91" (all product names) from Sanwa Chemical Co., Ltd., and "CPI-410S", "CR-C1", "CPI-410B", "CPI-310B", and "CPI-310FG" (all product names) from San-Apro Ltd. In addition, the instant composition may comprise, for example, basic substances such as amines, photosensitizers such as anthracene derivatives, and silane coupling agents for the purpose of improving, inter alia the photolithographic performance and adhesion performance.

The content of the cationic polymerization catalyst can be varied as appropriate in correspondence to the resin being used and is not particularly limited. The content of the cationic polymerization catalyst is preferably in the range 0.5 to 5 mass parts per 100 mass parts for the total of the epoxy resin (A) and epoxy resin (B) comprised in the photosensitive resin composition.

Cure Accelerator

The photosensitive resin composition may comprise a phenolic compound or a polyol having at least 2 hydroxyl groups as a cure accelerator. The addition of these results in acceleration of the cationic polymerization reaction of the epoxy resins.

Specific examples of the phenolic compounds include cardanol, terpene diphenol, and derivatives thereof. Examples are cardanol compounds such as cardanol and cardanol derivatives. Cardanol derivatives can be exemplified by derivatives in which the - OH of cardanol has been epoxy-modified. Commercially available products include "Cardolite NX-2026", "Cardolite NC-510", "Cardolite LITE 2020", and "Cardolite Ultra LITE 513" from the Cardolite Corporation.

When the polyol has one hydroxyl group, there is little effect with regard to promoting the cationic polymerization reaction of the epoxy resins, and as a consequence the polyol preferably has two or more hydroxyl groups. In addition, from the standpoints of the solubility in resins and solvents and the reactivity, the polyol preferably has a number-average molecular weight of 3000 or less. In addition, in order to not disappear during a heating step, the polyol preferably has a number-average molecular weight of 200 or more, or a boiling point of 200°C or more. The number-average molecular weight can be calculated as polystyrene by a known method using gel permeation chromatography (for example, from the Shimadzu Corporation).

The polyol can be specifically exemplified by polyethylene glycols (200, 300, 400, 600, 1000, 2000), which are commercially available from various companies. In addition, polyether polyols can be exemplified by the "ADEKA POLYETHER P series", "BPX series", "G series", "SP series", "SC series", "CM series", "AM series", "EM series", "BM series", "PR series", and "GR series" (all product names) from the ADEKA Corporation.

The polyol may be a low-molecular-weight polyhydric alcohol. Low-molecular-weight polyhydric alcohols can be exemplified by 1,2- or 1,6-hexanediol, glycerol, trimethylolpropane, 3-methyl-1,5-pentanediol, 1,2,6-hexanetriol, 1,5-dihydroxypentan-3-one, 6-hydroxycaproic acid, and 2-hydroxymethyl-1,3-propanediol. One or more of these can be used.

The content of the cure accelerator can be varied as appropriate in correspondence to the resin being used and is not particularly limited. The content of the cure accelerator is preferably in the range 1 to 8 mass parts per 100 mass parts for the total of the epoxy resin (A) and epoxy resin (B) comprised in the photosensitive resin composition.

Coating Solvents

When the photosensitive resin composition is to be applied in the form of a solution as a coating, a polar organic solvent is preferably used as the coating solvent from a solubility standpoint. Specific examples here are polar solvents, e.g., alcohols; ketones; esters such as ethyl acetate, butyl acetate, and propylene glycol monomethyl ether acetate (PGMEA); ethers such as diglyme, tetrahydrofuran, and propylene glycol monomethyl ether (PGME); and glycols such as diethylene glycol. The alcohols can be exemplified by methanol, ethanol, propanol, isopropanol, and butanol, and the ketones can be exemplified by methyl ethyl ketone and methyl isobutyl ketone.

Methods for producing the liquid-repellent anti-fouling film according to the present disclosure are described in the following.

Methods for Producing the Liquid-Repellent Anti-Fouling Film

The liquid-repellent anti-fouling film is a cured product from the photosensitive resin composition. That is, the photosensitive resin composition can be used as a resin composition for forming the liquid-repellent anti-fouling film.

For example, a coating film of the photosensitive resin composition may be produced on a substrate using a general-purpose coating device, e.g., a spin coater, die coater, slit coater, spray coater, and so forth. Dip coating can also be used here by adjusting the material concentrations.

The liquid-repellent anti-fouling film can be formed by curing the coating film surface by irradiation with light and as necessary carrying out a heat treatment and washing. The following can be used as the exposure device: a projection exposure device having a single-wavelength light source, e.g., an i-line exposure stepper or a KrF stepper, or having a mercury lamp broad-wavelength light source, e.g., a "Mask Aligner MPA-600 Super" (product name) from Canon, Inc.

As an example of the application of the liquid-repellent anti-fouling film, a method for producing an inkjet recording head is described in the following with reference to the drawings. The range of applications of the liquid-repellent anti-fouling film according to the present disclosure is not limited to this.

Method for Producing a Recording Head

FIG. 1A is a schematic diagram that gives an example of an inkjet recording head, and FIG. 1B is a cross-sectional diagram in which this recording head is visualized in a cross section perpendicular to the substrate 1 along A - B in FIG. 1A.

The recording head depicted in FIGS. 1A and 1B has a substrate 1 in which energy-generating elements 2, which generate energy employed to discharge a liquid, are arranged at a prescribed pitch in two rows side by side. A liquid supply port 3 is opened in the substrate 1 between the two rows of the energy-generating elements 2. Discharge ports 5 are formed on the substrate 1 by a discharge port-forming member 4 and are disposed at positions facing each of the energy-generating elements 2.

The shape of the discharge port 5 may be a so-called tapered shape whereby the area of the cross section parallel to the substrate 1 decreases from the substrate 1 side toward the discharge port 5. The discharge port-forming member 4 is composed of: a side wall 8 that forms individual flow paths 6 that communicate from the supply port 3 to each discharge port 5; and a top plate 9 in which the discharge ports 5 open. The side wall 8 and the top plate 9 in the discharge port-forming member 4 may be integrated into a single body.

A liquid-repellent anti-fouling film (liquid-repellent layer) 7 is provided on the discharge port-forming member. For example, the inkjet recording head may have the liquid-repellent anti-fouling film 7 on the surface in which the discharge ports are disposed. The liquid-repellent anti-fouling film 7 suppresses adhesion of the ink discharged from the discharge ports 5 to the surface of the recording head. The shape, material, and so forth of the substrate 1 are not particularly limited as long as the substrate 1 can function as a part of the member constituting the flow path 6 and can function as a support for the discharge port-forming member 4. In the present embodiment, a silicon substrate is used for the substrate 1 based on ease of processing.

This recording head is disposed such that the recording surface of the recording medium is faced by the recording head surface in which the discharge ports 5 open. Recording is carried out as follows: energy generated by an energy-generating element 2 is imparted to the ink filled in a flow path 6 via the supply port 3, causing ink droplets to be discharged from a discharge port 5 and adhere to the recording medium. The following, for example, can be used for the energy-generating element 2: for example, an electrothermal conversion element (a so-called heater) as an element that generates energy by heating; or, for example, a piezoelectric element as an element that generates energy mechanically.

The liquid-repellent anti-fouling film 7 is a cured product from the photosensitive resin composition. In specific terms, the liquid-repellent anti-fouling film 7 can be formed by the coating application of a solution comprising the photosensitive resin composition and by curing the coating film of this solution to form a liquid-repellent anti-fouling film that is the cured product.

An example of a method for producing an inkjet recording head is described in the following with reference to FIGS. 2A to 2H. Except for the liquid-repellent anti-fouling film 7, known components can be used in the inkjet recording head.

FIGS. 2A to 2H are schematic cross-sectional diagrams that show, in accordance with the steps involved, an example of a method for producing an inkjet recording head, and the position of the cross section is the same as in FIG. 1B.

First, as shown in FIG. 2A, a substrate 1 having energy-generating elements 2 provided in its surface is prepared. An electrode (not shown) for inputting a control signal for operating an energy-generating element 2 is connected to the element. Various functional layers may also be provided, e.g., a protective layer (not shown) for improving the durability of an energy-generating element 2 and an adhesion-improving layer (not shown) for improving the adhesion between the discharge port-forming member 4 and the substrate 1.

As shown in FIG. 2B, an ink supply port 3 is then formed that passes through the substrate 1. The supply port 3 can be formed by wet etching using an alkaline etching solution such as tetramethylammonium hydroxide (TMAH) or by dry etching such as reactive ion etching.

As shown in FIG. 2C, a first photosensitive resin layer 10 comprising a photosensitive resin and a photopolymerization initiator is then formed on the substrate 1 that comprises the energy-generating elements 2. The first photosensitive resin layer 10 is a so-called negative-type photosensitive resin layer. The first photosensitive resin layer 10 preferably is formed by coating a photosensitive resin on a film substrate made of PET or polyimide and transferring onto the substrate 1 using a lamination method. An epoxy resin can be advantageously used for the photosensitive resin present in the first photosensitive resin layer 10 because this satisfies various performance requirements, e.g., high mechanical strength, adhesion to the underlayer, ink resistance, and resolution for patterning the fine pattern of the discharge ports 5.

The same epoxy resin and photopolymerization initiator as described above can be used for the epoxy resin and photopolymerization initiator here.

The amount of addition of the photopolymerization initiator can be any amount of addition that achieves a target sensitivity. The amount of addition of the photopolymerization initiator is preferably in the range 0.5 to 5 mass% relative to the epoxy resin. A wavelength sensitizer may be added as necessary. An example of such a wavelength sensitizer is

"SP-100" (product name) from the ADEKA Corporation.

Additives may be added as necessary and appropriate to the hereinabove-described photosensitive resin composition. For example, a flexibility-imparting agent may be added with the goal of lowering the elastic modulus of the epoxy resin, or a silane coupling agent may be added in order to obtain greater adhesive strength with the underlayer.

As shown in FIG. 2D, a side wall 8 is then formed by patternwise exposure through a mask (not shown) followed by a heat treatment. The mask comprises a light-blocking film, e.g., a chromium film, formed, in conformity to the pattern of the flow paths 6, on a substrate composed of a material, e.g., glass or quartz, that transmits light at the exposure wavelength. The following can be used as the exposure device: a projection exposure device having a single-wavelength light source, e.g., an i-line exposure stepper or a KrF stepper, or having a mercury lamp broad-wavelength light source, e.g., a "Mask Aligner MPA-600 Super" (product name) from Canon, Inc.

As shown in FIG. 2E, a second photosensitive resin layer 11 is formed on the substrate 1 on which the side walls 8 have thusly been formed. The second photosensitive resin layer 11 is a negative-type photosensitive resin layer like the first photosensitive resin layer 10. A bisphenol epoxy resin or a novolac epoxy resin is preferably used as the photosensitive resin contained in the second photosensitive resin layer 11. The second photosensitive resin layer 11 can be formed by a method like that for the first photosensitive resin layer 10.

As shown in FIG. 2F, there is then formed, on the second photosensitive resin layer 11, a coating film 12 of a solution of the photosensitive resin composition for forming the hereinabove-described liquid-repellent anti-fouling film 7. The coating film 12 can be formed by coating this photosensitive resin composition using a method such as spin coating, roll coating, slit coating, and so forth.

As shown in FIG. 2G, the top plate 9 and the liquid-repellent anti-fouling film 7 are then formed by patternwise exposure through a mask (not shown) followed by curing. The mask comprises a light-blocking film, e.g., a chromium film, formed in conformity to the pattern of the discharge ports 5 on a substrate composed of a material, e.g., glass or quartz, that transmits light at the exposure wavelength. The following can be used as the exposure device: a projection exposure device having a single-wavelength light source, e.g., an i-line exposure stepper or a KrF stepper, or having a mercury lamp broad-wavelength light source, e.g., a "Mask Aligner MPA-600 Super" (product name) from Canon, Inc.

As shown in FIG. 2H, the unexposed portions of the second photosensitive resin layer 11 and the coating film 12 are then removed by a development process to form the discharge ports 5. By exposing and developing both the second photosensitive resin layer 11 and the coating film 12 at the same time, the cationic polymerizable groups in the second photosensitive resin layer 11 and the coating film 12 can react with each other to yield a highly durable liquid-repellent anti-fouling film 7 having strong antistatic properties. The unexposed portions of the first photosensitive resin layer 10 are also dissolved and removed at the same time to form the flow paths 6.

A heat treatment is also performed as necessary, and members for supplying ink (not shown) are connected and electrical connections (not shown) for driving the energy-generating elements 2 are made in order to complete the inkjet recording head.

## Recording Method

The recording method according to an embodiment of the present disclosure records an image on a recording medium by using the hereinabove-described inkjet recording head to discharge a liquid, particularly an ink comprising, e.g., a pigment and/or an alkaline component, from the inkjet recording head.

When some of the ink adheres in the vicinity of the nozzle during discharge by an inkjet recording head, discharge may become unstable and the print quality may be affected. When the inkjet recording head according to the present disclosure is used, ink adhesion in the vicinity of the nozzle or at the surface can be suppressed, even during long-term use, because the liquid-repellent anti-fouling film 7 has a high liquid repellency. Examples

The present disclosure will be specifically described hereinbelow with reference to Examples, but the present disclosure is not limited following Examples.

## Epoxy Resin (A)

The compounds given by the following formulas (a) to (c) were prepared as the epoxy resin (A).

(a)

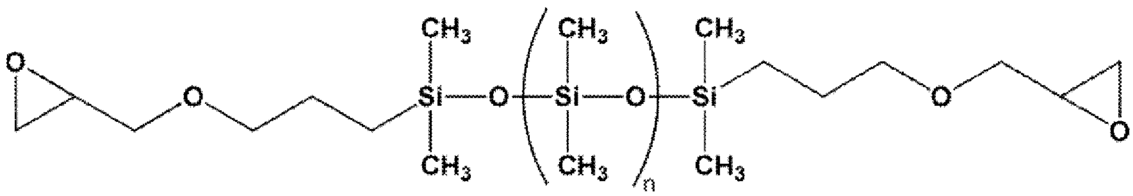

(n = 44)

(b)

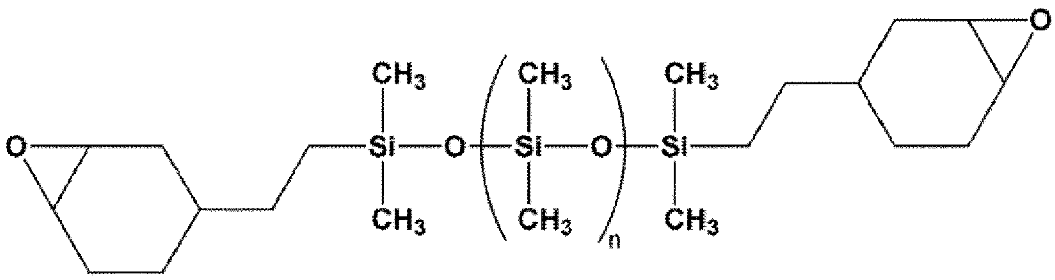

(n = 40)

(c)

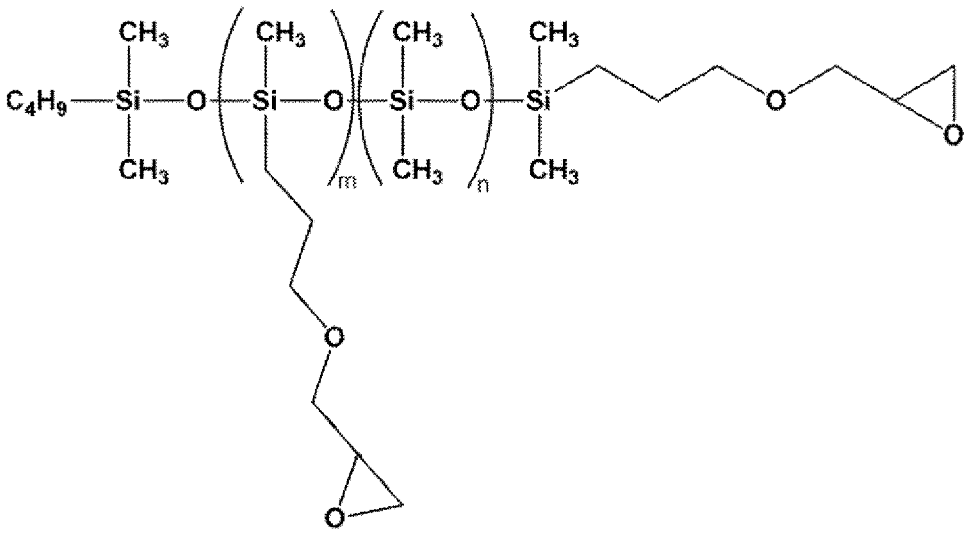

(m = 1, n = 30)

Epoxy Resin (B)

The compounds given in Table 1 were prepared for epoxy resin (B).

[Table 1]

| Product name | Manufacturer | Resin skeleton | Epoxy equivalent (g/eq.) |
|---|---|---|---|
| EHPE3150 | Daicel Corporation | alicyclic type | 170-190 |
| jER157S70 | Mitsubishi Chemical Corporation | bisphenol A novolac type | 200-220 |
| EPICLON N-695 | DIC Corporation | cresol novolac type | 209-219 |

(continued)

| Product name | Manufacturer | Resin skeleton | Epoxy equivalent (g/eq.) |
|---|---|---|---|
| EPICLON HP-7200L | DIC Corporation | dicyclopentadiene type | 242-252 |
| EPICLON HP-7200 | | | 254-264 |
| EPICLON HP-7200H | | | 272-284 |
| EPICLON HP-7200HH | | | 274-286 |
| EPICLON HP-7200HHH | | | 280-290 |
| DENACOL EM-160 | Nagase ChemteX Corporation | cresol novolac type | 450 |
| ADEKA RESIN EP-4005 | ADEKA Corporation | specialty epoxy resin | 510 |
| EPICLON 2050 | DIC Corporation | bisphenol A novolac type | 610-660 |
| jER1004 | Mitsubishi Chemical Corporation | | 875-975 |

Cationic Polymerization Catalysts

The compounds given in Table 2 were prepared as cationic polymerization catalysts.

[Table 2]

| Product name | Cation | Anion | Molar extinction coefficient $M^{-1} \cdot cm^{-1}$ | Manufacturer |
|---|---|---|---|---|
| CPI-410S | sulfonium | phosphorus type | 9600 | San-Apro Ltd. |
| CPI-410B | | borate type | 9600 | |
| CPI-310FG | | gallate type | 600 | |
| CPI-110P | | phosphorus type | 80 | |

Cure Accelerator

The compounds indicated in Table 3 were prepared as cured accelerators.

[Table 3]

| Product name | Manufacturer |
|---|---|
| Cardolite NX-2026 | Cardolite Corporation |
| Cardolite Ultra LITE 513 | |
| polyethylene glycol 600 | Various firms |

Formation of Liquid-Repellent Anti-Fouling Films

Example 1

The following procedure was used to prepare a solution for forming a liquid-repellent anti-fouling film. A coating solution was obtained by adding 1.0 mass part of the epoxy resin (A), 1.5 mass parts of CPI-410S (San-Apro Ltd.) as the cationic polymerization catalyst, and 250 mass parts of PGMEA as coating solvent to 100 mass parts of the epoxy resin (B) and stirring for 1 hour at room temperature.

The procedure for forming the liquid-repellent anti-fouling film is shown in FIGS. 3A to 3C. A coating film 12 was formed by coating the obtained solution on a silicon substrate 13 and a heat treatment was carried out for 3 minutes at 70°C. The coating film was then exposed through a mask (not shown) composed of quartz and a heat treatment was carried out for 5 minutes at 90°C. An i-line exposure stepper (FPA-3000i5+, Canon, Inc.) was used for the exposure device, and 5,000 J $m^{-2}$ was used for the exposure dose. The unexposed regions of the coating film were dissolved and removed using PGMEA and a heat treatment was also carried out for 1 hour at 200 °C to form a liquid-repellent anti-fouling film 7 and an opening 14.

Examples 2 to 16 and 20 to 22

Liquid-repellent anti-fouling films 7 were formed in the same manner as in Example 1, except for using the epoxy resin (A), epoxy resin (B), and cationic polymerization catalyst indicated in Table 6 and using the epoxy resin quantities shown in Table 6.

Examples 17 to 19

Liquid-repellent anti-fouling films 7 were formed in the same manner as in Example 1, except for using the epoxy resin (A), epoxy resin (B), and cure accelerator indicated in Table 6. The amount of addition of the cure accelerator was 5 mass parts per 100 mass parts of the epoxy resin (B).

Comparative Examples 1 to 3

Liquid-repellent anti-fouling films 7 were formed in the same manner as in Example 1, except for using the epoxy resin (A) and epoxy resin (B) indicated in Table 6.

Comparative Example 4

A liquid-repellent anti-fouling film 7 was formed in the same manner as in Example 1, except for using the epoxy resin (A), epoxy resin (B), and cure accelerator indicated in Table 6. The amount of addition of the cure accelerator was 5 mass parts per 100 mass parts of the epoxy resin (B).

Production of Inkjet Recording Heads

Example 23

Inkjet recording head production was carried out according to the process shown in FIGS. 2A to 2H.

As shown in FIG. 2A, a substrate 1 having energy-generating elements 2 provided in its surface was first prepared, and, as shown in FIG. 2B, an ink supply port 3 that passes through the substrate 1 was formed by etching using TMAH.

As shown in FIG. 2C, a first photosensitive resin layer 10 was then formed by transferring, by a lamination method, the cationic polymerizable resin composition shown in Table 4 onto the substrate 1 comprising the energy-generating elements 2. As shown in FIG. 2D, a side wall 8 was formed by carrying out patternwise exposure via a mask (not shown) composed of quartz and by carrying out a heat treatment for 5 minutes at 90°C. An i-line exposure stepper (FPA-3000i5+, Canon, Inc.) was used for the exposure device, and 10,000 J $m^{-2}$ was used for the exposure dose.

As shown in FIG. 2E, a second photosensitive resin layer 11 was formed on the substrate 1 on which the side wall 8 had been thusly formed. The second photosensitive resin layer 11 was transferred by a lamination method using the cationic polymerizable resin composition indicated in Table 5.

As shown in FIG. 2F, a liquid-repellent anti-fouling film 7 was formed by coating the coating solution obtained in Example 4 on the second photosensitive resin layer 11 and carrying out a heat treatment for 3 minutes at 70°C. A patternwise exposure, via a mask (not shown) bearing a pattern for the discharge ports 5, was carried out at the same time for both the second photosensitive resin layer 11 and the coating film 12, and a heat treatment was carried out for 5 minutes at 90°C. An i-line exposure stepper (FPA-3000i5+, Canon, Inc.) was used for the exposure device, and 5,000 J $m^{-2}$ was used for the exposure dose (FIG. 2G).

Finally, the unexposed regions of the photosensitive resin layer and coating film were dissolved and removed using PGMEA and a heat treatment was carried out for 1 hour at 200°C to form the discharge ports 5 and flow paths 6 (FIG. 2H).

[Table 4]

| | | |
|---|---|---|
| Epoxy resin | Product name : EPICLON N-695, manufactured by DIC Corporation | 100 mass parts |
| Photopolymerization initiator | Product name : ADEKA ARKLS SP-172, manufactured by ADEKA Corporation | 6 mass parts |
| Solvent | Product name : OMR Thinner, manufactured by Tokyo Ohka Kogyo Co., Ltd. | 70 mass parts |

[Table 5]

| | | |
|---|---|---|
| Epoxy resin | Product name : 157S70, manufactured by Mitsubishi Chemical Corp. | 100 mass parts |
| Photopolymerization initiator | Product name : CPI-410S, manufactured by San-Apro Ltd. | 0.01 mass parts |
| Solvent | Product name : PGMEA, manufactured by Kishida Chemical Co., Ltd. | 20 mass parts |

Comparative Example 5

Inkjet recording head production was carried out in the same manner as in Example 23, except for using the coating solution obtained in Comparative Example 1 for the coating solution used to form the liquid-repellent anti-fouling film 7.

Evaluation of the Liquid-Repellent Anti-Fouling Films

The following evaluations were performed for the liquid-repellent anti-fouling films prepared by the methods of Examples 1 to 22 and Comparative Examples 1 to 4.

Water Repellency

The liquid-repellent anti-fouling film was immersed for 1 week at 60°C in an aqueous solution that had been adjusted to pH of 12 or more and was then washed with water and dried. The water repellency was subsequently evaluated by measuring the contact angle of the surface of the liquid-repellent anti-fouling film. For the contact angle, the dynamic receding contact angle θr of the liquid-repellent anti-fouling film versus water was measured using a micro-contact angle meter ("DropMeasure" (product name) from the Microjet Corporation).

An evaluation of A was assigned when the water repellency was excellent with θr of 80° or more; an evaluation of B was assigned when θr is 70° or more and less than 80 °, where use as a liquid-repellent anti-fouling film is possible; and an evaluation of C was assigned when θr is less than 70°, in which the water repellency is insufficient for a liquid-repellent anti-fouling film.

Resolution

The resolution was evaluated by measuring the area of the opening. The area of the opening was measured using a scanning white interference microscope ("Vertscan" (product name) from the Hitachi High-Tech Corporation), and the resolution was evaluated by checking the reproducibility of the mask dimension. Thus, (((area of opening) - (mask dimension))/(mask dimension)) × 100 was determined, and a resolution of A was assigned for less than ± 3%, a resolution of B was assigned for ± 3% or more and less than ± 5%, and a score of C was assigned for ± 5% or more.

The results of these evaluations are given in the following Table 6.

[Table 6]

| | Epoxy resin (A)) | | Epoxy resin (B) | | | Cationic polymerization catalyst | | | Cure accelerator | Water repellency | Resolution |
|---|---|---|---|---|---|---|---|---|---|---|---|
| | Compound | amount of addition (mass parts) | Product name | Resin skeleton | Epoxy equivalent (g/eq.) | Product name | Cation structure | molar extinction coefficient $M^{-1} \cdot cm^{-1}$ | | | |
| Example 1 | (a) | 1.0 | EHPE3150 | alicyclic type | 170-190 | CP-I-410S | sulfonium ion | 9600 | - | A | A |
| Example 2 | (b) | 1.0 | EHPE3150 | alicyclic type | 170-190 | CP-I-410S | sulfonium ion | 9600 | - | A | A |
| Example 3 | (c) | 1.0 | EHPE3150 | alicyclic type | 170-190 | CP-I-410S | sulfonium ion | 9600 | - | A | A |
| Example 4 | (b) | 1.0 | jER157S70 | bisphenol A novolac type | 200-220 | CP-I-410S | sulfonium ion | 9600 | - | A | A |
| Example 5 | (b) | 1.0 | EPICLON N-695 | cresol novolac type | 209-219 | CP-I-410S | sulfonium ion | 9600 | - | A | A |
| Example 6 | (b) | 1.0 | EPICLON HP-7200L | dicyclopentadiene type | 242-252 | CP-I-410S | sulfonium ion | 9600 | - | A | A |
| Example 7 | (b) | 1.0 | EPICLON HP-7200 | dicyclopentadiene type | 254-264 | CP-I-410S | sulfonium ion | 9600 | - | A | A |
| Example 8 | (b) | 1.0 | EPICLON HP-7200H | dicyclopentadiene type | 272-284 | CP-I-410S | sulfonium ion | 9600 | - | A | A |
| Example 9 | (b) | 1.0 | EPICLON HP-7200HH | dicyclopentadiene type | 274-286 | CP-I-410S | sulfonium ion | 9600 | - | A | A |
| Example 10 | (b) | 1.0 | EPICLON HP-7200HHH | dicyclopentadiene type | 280-290 | CP-I-410S | sulfonium ion | 9600 | - | A | A |
| Example 11 | (b) | 1.0 | DENACOL EM-160 | cresol novolac type | 450 | CP-I-410S | sulfonium ion | 9600 | - | B | B |
| Example 12 | (b) | 0.2 | EHPE3150 | alicyclic type | 170-190 | CP-I-410S | sulfonium ion | 9600 | - | B | A |
| Example 13 | (b) | 0.3 | EHPE3150 | alicyclic type | 170-190 | CP-I-410S | sulfonium ion | 9600 | - | A | A |
| Example 14 | (b) | 10.0 | EHPE3150 | alicyclic type | 170-190 | CP-I-410S | sulfonium ion | 9600 | - | A | A |
| Example 15 | (b) | 30.0 | EHPE3150 | alicyclic type | 170-190 | CP-I-410S | sulfonium ion | 9600 | - | A | A |
| Example 16 | (b) | 40.0 | EHPE3150 | alicyclic type | 170-190 | CP-I-410S | sulfonium ion | 9600 | - | B | A |

(continued)

| | Epoxy resin (A)) | | Epoxy resin (B) | | | Cationic polymerization catalyst | | | Cure accelerator | Water repellency | Resolution |
|---|---|---|---|---|---|---|---|---|---|---|---|
| | Compound | amount of addition (mass parts) | Product name | Resin skeleton | Epoxy equivalent (g/eq.) | Product name | Cation structure | molar extinction coefficient $M^{-1} \cdot cm^{-1}$ | | | |
| Example 17 | | 1.0 | DENACOL EM-160 | cresol novolac type | 450 | | | | Cardolite NX-2026 | A | B |
| Example 18 | | 1.0 | | | | | | | Cardolite Ultra LITE 513 | A | B |
| Example 19 | | 1.0 | | | | | | | polyethylene glycol 600 | A | B |
| Example 20 | | 1.0 | EHPE3150 | alicyclic type | 170-190 | CPI-410B | | 9600 | - | A | A |
| Example 21 | | 1.0 | | | | CPI-310FG | | 600 | | A | A |
| Example 22 | | 1.0 | | | | CPI-110P | | 80 | | B | B |
| Comparative Example 1 | (b) | 1.0 | ADEKA RESIN EP-4005 | specialty epoxy resin | 510 | CPI-410S | sulfonium ion | 9600 | - | C | C |
| Comparative Example 2 | | | EPICLON 2050 | bisphenol A novolac type | 610-660 | | | | | C | C |
| Comparative Example 3 | | | jER1004 | | 875-975 | | | | | C | C |
| Comparative Example 4 | | | ADEKA RESIN EP-4005 | specialty epoxy resin | 510 | | | | Cardolite NX-2026 | C | C |

In the table, the quantity of addition represents the quantity of addition (mass parts) of the epoxy resin (A) per 100 mass parts of the epoxy resin (B).

Evaluation of the Liquid-Repellent Anti-Fouling Films

As shown in Table 6, an excellent water repellency could be exhibited in Examples 1 to 22. In particular, in Examples 1 to 10 and 12 to 16, due to the epoxy equivalent of the epoxy resin (B) being 300 or less, the reactivity with the epoxy resin (A) was excellent and a high resolution was exhibited.

In addition, focusing on the amount of addition of the epoxy resin (A), a higher water repellency was obtained in Examples 13 to 15 than in Examples 12 and 16. Based on this result, it was demonstrated that the mass ratio (A : B) between the epoxy resin (A) and the epoxy resin (B) is more favorably 0.3 : 100 to 30 : 100.

Moreover, in Examples 17 to 19, in which a cure accelerator was added, the reactivity with the epoxy resin (A) could be promoted and an excellent water repellency could be obtained even at a relatively high epoxy equivalent for the epoxy resin (B) of 450.

Focusing on the cationic polymerization catalyst, Examples 20 and 21 presented a higher water repellency and resolution than Example 22. Based on these results, it was demonstrated that a cationic polymerization catalyst with a molar extinction coefficient of 400 $M^{-1} \cdot cm^{-1}$ or more is more favorable.

On the other hand, both the water repellency and resolution were unsatisfactory in Comparative Examples 1 to 3, in which the epoxy equivalent of the epoxy resin (B) was 500 or more. The same result was also obtained in Comparative Example 4, in which a cure accelerator had been added.

Evaluation of Inkjet Recording Heads

A continuous printing test was carried out in a 30°C/80% RH environment using an MB5330 printer from Canon, Inc., and the presence/absence of dot distortion was visually checked. 100 sheets of A4 solid text were continuously printed in the continuous printing test. With regard to print distortion, the print quality was scored as NG if distortion was produced at even one location in an A4 print.

The results of these evaluations are as follows. In Example 23, there was no distortion even during continuous printing and a high print quality was observed. In Comparative Example 5, on the other hand, distortion was observed after the execution of continuous printing.

As described above, fluorine-based water repellent materials, while exhibiting good water repellencies, raise concerns about their impact on the environment. The photosensitive resin composition according to the present embodiment, on the other hand, exhibits good water repellency even without the incorporation of a fluorine-based water repellent material. The technology described in this Specification can therefore contribute to the realization of a sustainable society, e.g., a decarbonized/recycling society.

Various embodiments have been described in detail above but it will be understood that the present disclosure is not limited to these embodiments and encompasses all modifications, variants, alternatives and equivalents falling within the scope of the appended claims.

## Claims

**1.** A photosensitive resin composition comprising:

an epoxy resin (A) represented by formula (1);
an epoxy resin (B) that has an epoxy equivalent of 500 g/eq. or less and that is different from the epoxy resin (A) represented by formula (1); and
a cationic polymerization catalyst,

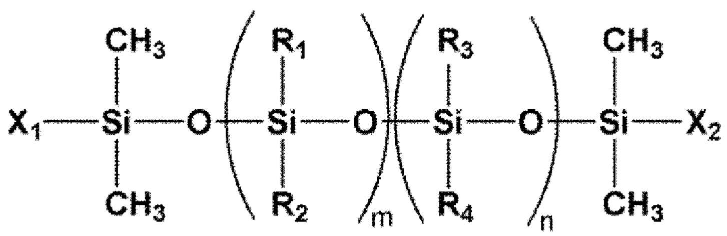

(1)

where, in formula (1), $R_1$, $R_2$, $R_3$, $R_4$, and $X_1$ are each independently an alkyl group with carbon numbers of 1 to 12, an aryl group with carbon numbers of 6 to 12, or an epoxy-comprising group; $X_2$ is an epoxy-comprising group; m + n is an integer from 1 to 60; and a sequence of a structure of parentheses marked with m and a sequence of a structure of parentheses marked with n may be random or block.

**2.** The photosensitive resin composition according to claim 1, wherein the epoxy equivalent of the epoxy resin (B) is 300 g/eq. or less.

**3.** The photosensitive resin composition according to claim 1 or 2, wherein the epoxy resin (B) is at least one selected from the group consisting of epoxy resin having an alicyclic skeleton, epoxy resin having a bisphenol skeleton, epoxy resin having a phenol novolac skeleton, epoxy resin having a cresol novolac skeleton, epoxy resin having a norbornene skeleton, epoxy resin having a terpene skeleton, epoxy resin having a dicyclopentadiene skeleton, and epoxy resin having an oxycyclohexane skeleton.

**4.** The photosensitive resin composition according to any one of claims 1 to 3, wherein the $R_1$, the $R_2$, the $R_3$, and the $R_4$ are each independently an alkyl group with carbon numbers of 1 to 12 or an aryl group with carbon numbers of 6 to 12.

**5.** The photosensitive resin composition according to claim 4, wherein the $X_1$ is an epoxy-comprising group.

**6.** The photosensitive resin composition according to any one of claims 1 to 5, wherein a mass ratio (A : B) between the epoxy resin (A) and the epoxy resin (B) is from 0.3 : 100 to 30 : 100.

**7.** The photosensitive resin composition according to any one of claims 1 to 6, wherein the photosensitive resin composition comprises a phenolic compound or a polyol having at least 2 hydroxyl groups as a cure accelerator.

**8.** The photosensitive resin composition according to any one of claims 1 to 7, wherein a cation in the cationic polymerization catalyst is a sulfonium ion.

**9.** The photosensitive resin composition according to any one of claims 1 to 8, wherein a molar extinction coefficient of the cationic polymerization catalyst at a wavelength of 365 nm is 400 $M^{-1} \cdot cm^{-1}$ or more.

**10.** The photosensitive resin composition according to any one of claims 1 to 9, wherein an anion in the cationic polymerizable catalyst is at least one selected from the group consisting of tetrakis(pentafluorophenyl)borate ion, trifluorotris(pentafluoroethyl)phosphate ion, hexafluoroantimonate ion, and tetrakis(pentafluorophenyl)gallate ion.

**11.** A liquid-repellent anti-fouling film (7) that is a cured product of a photosensitive resin composition, wherein the photosensitive resin composition comprises:

an epoxy resin (A) represented by formula (1);
an epoxy resin (B) that has an epoxy equivalent of 500 g/eq. or less and that is different from the epoxy resin (A) represented by formula (1); and
a cationic polymerization catalyst,

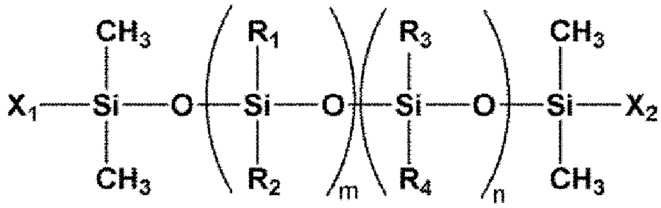
(1)

where, in formula (1), $R_1$, $R_2$, $R_3$, $R_4$, and $X_1$ are each independently an alkyl group with carbon numbers of 1 to 12, an aryl group with carbon numbers of 6 to 12, or an epoxy-comprising group; $X_2$ is an epoxy-comprising group; m + n is an integer from 1 to 60; and a sequence of a structure of parentheses marked with m and a sequence of a structure of parentheses marked with n may be random or block.

**12.** An inkjet recording head that has a liquid-repellent anti-fouling film (7) on a surface in which a discharge port (5) is disposed, wherein

the liquid-repellent anti-fouling film is a cured product of the photosensitive resin composition according to any one of claims 1 to 10.

Fig. 1A

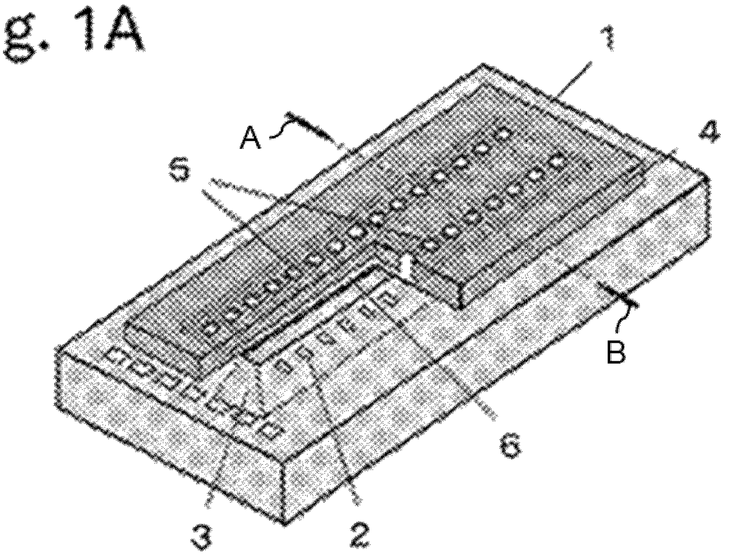


Fig. 1B

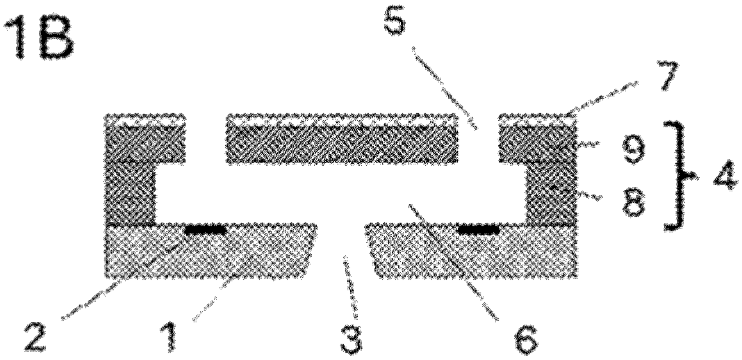

Fig. 2A

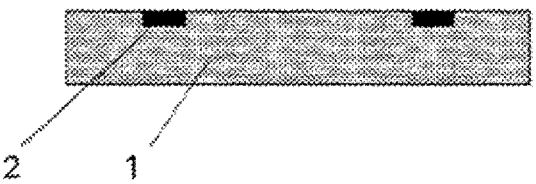


Fig. 2B

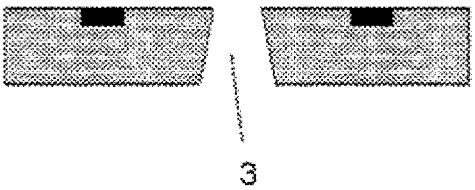


Fig. 2C

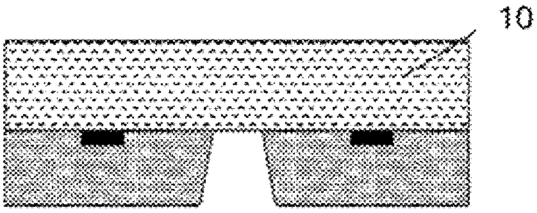


Fig. 2D

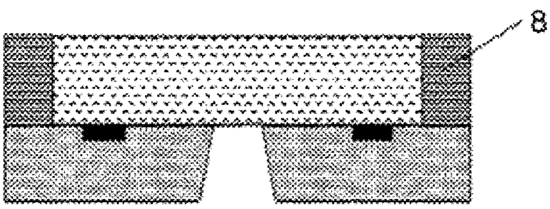


Fig. 2E

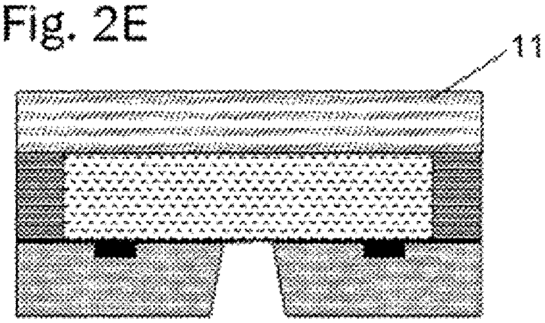


Fig. 2F

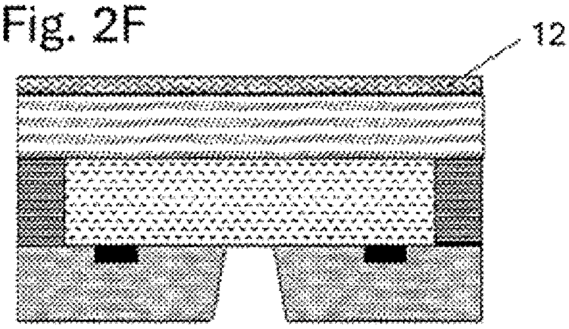


Fig. 2G

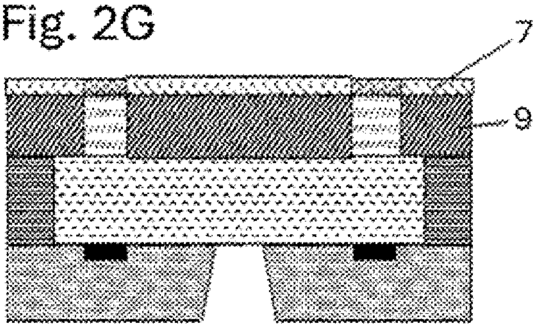


Fig. 2H

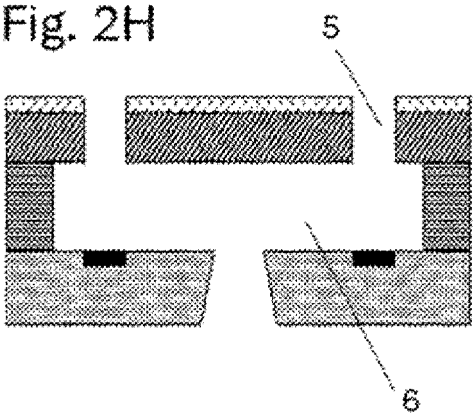

Fig. 3A

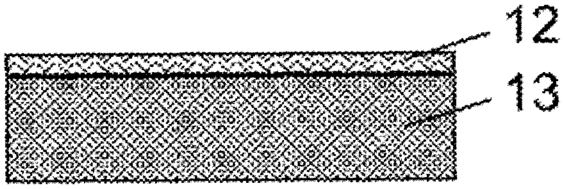


Fig. 3B

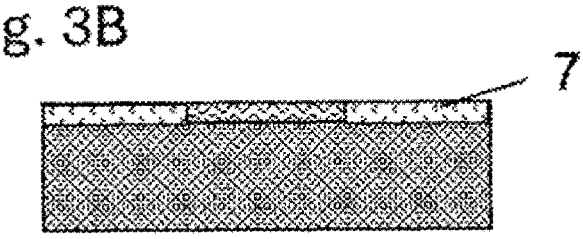


Fig. 3C

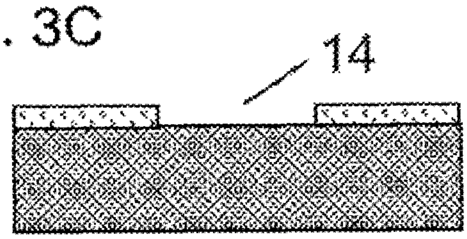

Europäisches Patentamt
European Patent Office
Office européen des brevets

# EUROPEAN SEARCH REPORT

Application Number
EP 25 19 3967

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | JP WO20 1616 7347 A1 (SEKISUI CHEMICAL CO LTD) 27 April 2017 (2017-04-27)<br>* example 10 *<br>* claims 1, 3 *<br>* paragraphs [0008], [0087], [0092], [0095], [0115] *<br>* Formula (3-2) p. 26 *<br>----- | 1-5,8, 10,11<br>12<br>6 | INV.<br>B41J2/16<br>C08G59/04<br>C08G59/06<br>C08G59/08<br>C08G59/30<br>C08G59/62<br>C08G59/68<br>C08L63/00<br>C08G59/24<br>C08G77/14<br>C08L63/04 |
| Y,D<br>A | JP 2003 020323 A (CANON KK)<br>24 January 2003 (2003-01-24)<br>* paragraphs [0001], [0019], [0023] - [0026], [0055] - [0063], [0066] - [0074], [0085] *<br>* examples 1, 2, 7, 8 *<br>* examples 1-4 *<br>* tables 1-4 *<br>----- | 7,9,12<br>6 | |
| Y | EP 1 157 057 B1 (3M INNOVATIVE PROPERTIES CO [US]) 23 August 2006 (2006-08-23)<br>* paragraphs [0007], [0015] *<br>----- | 7 | TECHNICAL FIELDS SEARCHED (IPC) |
| Y | JP 2019 183048 A (NIPPON KAYAKU KK)<br>24 October 2019 (2019-10-24)<br>* paragraphs [0052] - [0053] *<br>* table 1 *<br>* example 1 *<br>----- | 9 | C08G<br>C08L<br>B41J<br>C09J |
| Y | JP 2006 348199 A (TOYO INK MFG CO)<br>28 December 2006 (2006-12-28)<br>* Table on p. 29;<br>table 1 *<br>----- | 9 | |

The present search report has been drawn up for all claims

1

| Place of search | Date of completion of the search | Examiner |
|---|---|---|
| The Hague | 19 December 2025 | Smit, Theo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 25 19 3967

This annex lists the patent family members relating to the patent documents cited in the above-mentioned European search report. The members are as contained in the European Patent Office EDP file on
The European Patent Office is in no way liable for these particulars which are merely given for the purpose of information.

19-12-2025

| Patent document cited in search report | Publication date | Patent family member(s) | Publication date |
|---|---|---|---|
| JP WO2016167347 A1 | 27-04-2017 | CN 107109190 A | 29-08-2017 |
| | | JP 6200591 B2 | 20-09-2017 |
| | | JP 2018049817 A | 29-03-2018 |
| | | JP WO2016167347 A1 | 27-04-2017 |
| | | KR 20170140149 A | 20-12-2017 |
| | | TW 201704436 A | 01-02-2017 |
| | | WO 2016167347 A1 | 20-10-2016 |
| JP 2003020323 A | 24-01-2003 | NONE | |
| EP 1157057 B1 | 23-08-2006 | AU 4182199 A | 24-07-2000 |
| | | BR 9916703 A | 25-09-2001 |
| | | CA 2355319 A1 | 13-07-2000 |
| | | CN 1332759 A | 23-01-2002 |
| | | DE 69932947 T2 | 06-09-2007 |
| | | EP 1157057 A1 | 28-11-2001 |
| | | EP 1757633 A1 | 28-02-2007 |
| | | JP 4436984 B2 | 24-03-2010 |
| | | JP 2002534545 A | 15-10-2002 |
| | | KR 20010089752 A | 08-10-2001 |
| | | US 6265459 B1 | 24-07-2001 |
| | | WO 0040636 A1 | 13-07-2000 |
| JP 2019183048 A | 24-10-2019 | NONE | |
| JP 2006348199 A | 28-12-2006 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003020323 A